# EUROPEAN PATENT APPLICATION

(11) **EP 2 071 639 A1**
(43) Date of publication of application: **17.06.2009**
(21) Application number: 07849827.6
(22) Date of filing: 13.12.2007
(51) Int. Cl.: H01L 33/00, B29C 43/18, B29C 43/36, B29C 43/56, H01L 21/56, B29L 11/00

(54) **METHOD OF FORMING LIGHT EMITTER AND METAL MOLD**

(30) Priority: 20.02.2007 JP 2007038962
(71) Applicant: Towa Corporation, Kyoto 6018105 (JP)
(72) Inventor: KAWAKUBO, Kazuki, Kyoto-shi Kyoto 601-8105 (JP); TAKASE, Shinji, Kyoto-shi Kyoto 601-8105 (JP)
(74) Representative: Hoeger, Stellrecht & Partner Patentanwälte
(86) International application number: PCT/JP2007/001394
(87) International publication number: WO 2008/102419

(57) **Abstract**

The manufacturing efficiency of a light emitter 4 (product) having a lens member 6 and a light emitting device I is efficiently improved. With a molding die 11 for forming a light emitter, a frame 2 before the molding and bonding process, with a required number of light-emitting devices I mounted thereon, is set on a setting section 14 provided in an upper die 12. A required amount of transparent liquid resin material 24 is supplied by a dispenser 23 into each of cavities 17 of cavity blocks 18 provided in a lower die 13 in correspondence to the light-emitting devices 1, respectively. A molding die 11-12 is closed so as to elastically press the mouths 22 of the cavities 17 onto the light emission surfaces 3 of the light emitting devices 1, respectively. Thus, the resin in each cavity 17 is compression-molded into the lens member 6 formed in accordance with the shape of the cavity, and simultaneously, the lens members 6 are bonded to the light emission surfaces 3 of the light emitting devices 1 to obtain a light emitter 4 and accordingly a frame 5 after the molding and bonding process.

## Description

### TECHNICAL FIELD

The present invention relates to the improvement of a method of forming a light emitter having a tight-emitting element such as a light-emitting diode (LED) chip, and also to the improvement of a molding die for such a method.

### BACKGROUND ART

A conventional method of forming a light emitter (product) includes bonding a pre-molded lens member (optical member) to an LED light-emitting device (light-emitting part) mounted on a frame.

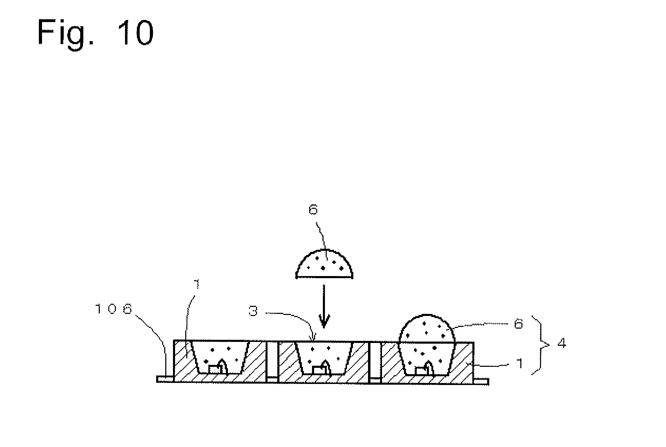

That is to say, as illustrated in Fig. 10, a light-emitter 4 is formed by bonding a lens member 6 to an emission surface 3 of an LED light-emitting device 1 mounted on a frame 106.
The applicant has conducted a prior-art search on patent publications and other documents but found no document disclosing the aforementioned method.

### DISCLOSURE OF THE INVENTION

### PROBLEM TO BE SOLVED BY THE INVENTION

As just explained, the aforementioned method includes bonding the lend member 6 on the light-emitting surface 3 of the light-emitting device 1. This method requires the process of pre-molding the lens member 6 and also the process of bonding the same member 6 to the light-emitting device 1.
Since these two processes are sequentially and separately performed, the manufacturing efficiency of the light emitter 4 (product) formed by those two processes is low. Thus, the method has the problem that the manufacturing efficiency of the product cannot be efficiently improved.

Accordingly, the present invention is aimed at efficiently improving the manufacturing efficiency of the product in the case of forming a product (light emitter 4) consisting of a light-emitting part (light-emitting device 1) and an optical member (lens member 6).

### MEANS FOR SOLVING THE PROBLEMS

The present invention aimed at solving the aforementioned technical problem provides a method of forming a light emitter, using a molding die including upper and lower dies for forming a light emitter. This method is characterize by the following processes: supplying and setting a frame, with a required number of light-emitting parts mounted thereon, onto a frame-setting section provided in the upper die, and also supplying a required amount of resin material into each of the cavities of the cavity blocks provided in the lower die in a vertically slidable manner, each cavity block having the cavity for molding and bonding an optical member; closing the molding die; elastically and individually pressing the cavity mouths of the cavity blocks onto the emission surfaces of the light-emitting parts, respectively, in the process of closing the molding die; compression-molding the resin in the cavities to form the optical members in the process of elastically pressing the cavities; bonding the optical members, which have been individually molded within the cavities in accordance with the shape of the cavity, to the light-emitting parts, respectively, in the process of elastically pressing the cavities; and simultaneously performing the processes of compression-molding the optical members and bonding the optical members to the light-emitting parts, to form a light emitter including the light-emitting part and the optical member.

The present invention aimed at solving the aforementioned technical problem also provides a method of forming a light emitter, using a molding die including upper and lower dies for forming a light emitter. This method is characterized by the following processes: supplying and setting a frame, with a required number of light-emitting parts mounted thereon, onto a frame-setting section provided in the upper die, and also supplying a required amount of resin material into each of the cavities of the cavity blocks provided in the lower die in a vertically slidable manner, each cavity block having the cavity for molding and bonding an optical member; closing the molding die; elastically and individually pressing the cavity mouths of the cavity blocks onto the emission surfaces of the light-emitting parts, respectively, in the process of closing the molding die; and immersing the light-emitting parts in the resin contained in the cavities and compression-molding the light-emitting parts in the process of elastically pressing the cavities, to resin-encapsulate, within each cavity, an optical part in the optical member formed in accordance with the shape of the cavity and thereby form a light emitter.

In one mode of the present invention aimed at solving the aforementioned technical problem, the method of forming a light emitter is further characterized by the process of covering the inner surface of the cavities with a mold release film before supplying the resin material into the cavities.

In another mode of the present invention aimed at solving the aforementioned technical problem, the method of forming a light emitter is further characterized by the processes of shutting off outside air from, at the very least, the inside of the cavities provided in the molding die, thus forming an outside-air shut-off region, and then forcefully evacuating air from the outside-air shut-off region to maintain the outside-air shut-off region at a required degree of vacuum.

The present invention aimed at solving the aforementioned technical problem also provides a molding die for forming a light emitter, which is characterized by: an upper die; a lower die facing the upper die; a setting section provided in the upper die, onto which a frame with a required number of optical parts mounted thereon is to be supplied and set; a required number of lower-die cavities formed for the optical parts, respectively; cavity blocks provided in the lower die in a vertically slidable manner, each cavity block having one of the cavities; and elastic bodies elastically supporting each of the cavity blocks upwards.

In one mode of the present invention aimed at solving the aforementioned technical problem, the molding die for forming a light emitter is further characterized by a mold release film for covering the inner surface of the cavities.

In another mode of the present invention aimed at solving the aforementioned technical problem, the molding die for forming a light emitter is further characterized by a vacuum mechanism for forcefully evacuating air from an outside-air shut-off region which at least includes the inside of the cavities to maintain the outside-air shut-off region at a required degree of vacuum.

In another mode of the present invention aimed at solving the aforementioned technical problem, the molding die for forming a light emitter is further characterized in that the optical part is a light-emitting element.

### EFFECT OF THE INVENTION

The present invention has the beneficial effect of efficiently improving the manufacturing efficiency of the product in the case of forming a product (light emitter) consisting of a light-emitting part and an optical member.

### BRIEF DESCRIPTION OF THE DRAWING

Fig. 1 is a schematic vertical sectional view illustrating a molding die for forming a light emitter according to the present invention, the view schematically showing the molding die with the dies in the open state before the light emitter is formed.
Fig. 2 is a schematic vertical sectional view showing the same molding die as the one shown in Fig. 1, with the dies in the closed state.
Fig. 3 is a schematic vertical sectional view showing the same molding die as the one shown in Fig. 1, with the dies in the open state after the light emitter is formed.
Fig. 4 is a schematic vertical sectional view illustrating another molding die for forming a light emitter according to the present invention, the view schematically showing the molding die with the dies in the open state before the light emitter is formed.
Fig. 5 is a schematic vertical sectional view showing the same molding die as the one shown in Fig. 4, with the dies in the closed state.
Fig. 6 is a schematic vertical sectional view illustrating another molding die for forming a light emitter according to the present invention, the view schematically shewing the molding die with the dies in the open state before the light emitter is formed.
Fig. 7 is a schematic vertical sectional view showing the same molding die as the one shown in Fig. 6, with the dies in the closed state.
Fig. 8 is a schematic vertical sectional view showing the same molding die as the one shown in Fig. 6, with the dies in the open state after the light emitter is formed.
Fig. 9(1) is a schematic vertical sectional view of light-emitting devices mounted on a frame before a pre-molding process, Fig. 9(2) is a schematic vertical sectional view of the frame (light-emitting devices) before the molding and bonding process, Fig. 9(3) is a schematic vertical sectional view of the frame (light-emitting devices) after the molding and bonding process, and Fig. 9(4) is a schematic vertical sectional view of the light-emitting device.
Fig. 10 is a schematic vertical sectional view of light emitters formed by a conventional method and mounted on a frame.

### EXPLANATION OF NUMERALS

- 1: Light-Emitting Device
- 2: Frame before Molding and Bonding Process
- 3: Emission Surface
- 4: Light Emitter
- 5: Frame after Molding and Bonding Process
- 6: Lens Member
- 7: Frame before Molding and Bonding Process (Ante-Molding/Bonding Frame)
- 8: Frame after Molding and Bonding Process (Post-Molding/Bonding Frame)
- 11: Molding Die for Forming Light Emitter
- 12: Fixed Upper Die
- 13: Movable Lower Die
- 14: Frame-Setting Section
- 15: Frame-Fixing Means
- 16: Lower Die Body
- 17: Cavity
- 18: Cavity Block
- 19: Base
- 20: Cavity Elastic Member
- 21: Lower Die Elastic Member
- 22: Cavity Mouth
- 23: Vertical Dispenser
- 24: Liquid Resin Material
- 31: Molding Die for Forming Light Emitter
- 32: Fixed Upper Die
- 33: Movable Lower Die
- 34: Central Die (Intermediate Plate)
- 35: Mold Release Film
- 36: Lower Die Body
- 41: Ante-Molding Frame
- 42: LED Chip
- 43: Frame
- 44: Lens Member
- 45: Light Emitter
- 46: Molded Frame
- 47: Horizontal Dispenser
- 101: LED Chip
- 102: Hollow
- 103: Main Body of Light-Emitting Device
- 104: Dispenser
- 105: Resin Material
- 106: Frame
- 107: Frame

### BEST MODE FOR CARRYING OUT THE INVENTION

The best mode for carrying out the present invention is as follows: Firstly, in a molding die for forming a light emitter according to the present invention, a frame before the molding and bonding process, with a required number of light-emitting devices (optical parts) mounted thereon, is supplied and set by a frame transfer mechanism onto the setting section provided in the upper die; meanwhile a required amount of transparent liquid resin material is dripped by a dispenser into each of the lower-die cavities provided for the light-emitting devices, respectively.
Next, the molding die is closed to bring the molding surfaces (one cavity mouth) of the cavity blocks, each block having one lower-die cavity, into contact with the emission surfaces of the light-emitting devices, respectively.
In this process, the emission surfaces are elastically and individually pressed onto the molding surfaces of the cavity blocks by the elastic members, respectively, whereby a required resin pressure is individually applied to the resin contained in each cavity. As a result, a lens member (optical member) formed in accordance with the shape of the cavity is compression-molded (resin-encapsulated) within the cavity.
Simultaneously, the molding surfaces (cavity mouths) of the cavity blocks are elastically and individually pressed onto the emission surfaces, respectively, whereby the resin that is hardening within each cavity is elastically and individually pressed onto each emission surface (the resin contained in the hollow formed in the light-emitting device). Thus, the lens member that is compression-molded within each cavity is bonded to the emission surface to create a light emitter (product).
After a period of time required for the resin to harden has elapsed, the molding die is opened to obtain a frame after the molding and bonding process with the lens members bonded to the emission surfaces of the light-emitting devices, respectively.

As described previously, by using the molding die for forming a light emitter according to the present invention, it is possible to simultaneously perform the processes of compression-molding the lens member and bonding the same lens member, so that the light emitter consisting of the light-emitting device and the lens member can be more efficiently formed than in the case of the conventional example in which the processes of compression-molding the lens member and bonding the same lens member are sequentially performed.
Thus, in the case of forming a light emitter (product) consisting of a light-emitting device (light-emitting part) and a lens member (optical member), it is possible according to the present invention to efficiently improve the manufacturing efficiency of the product (light emitter).

### FIRST EMBODIMENT

The first embodiment of the present invention is hereinafter detailed on the basis of the figures illustrating the embodiment.

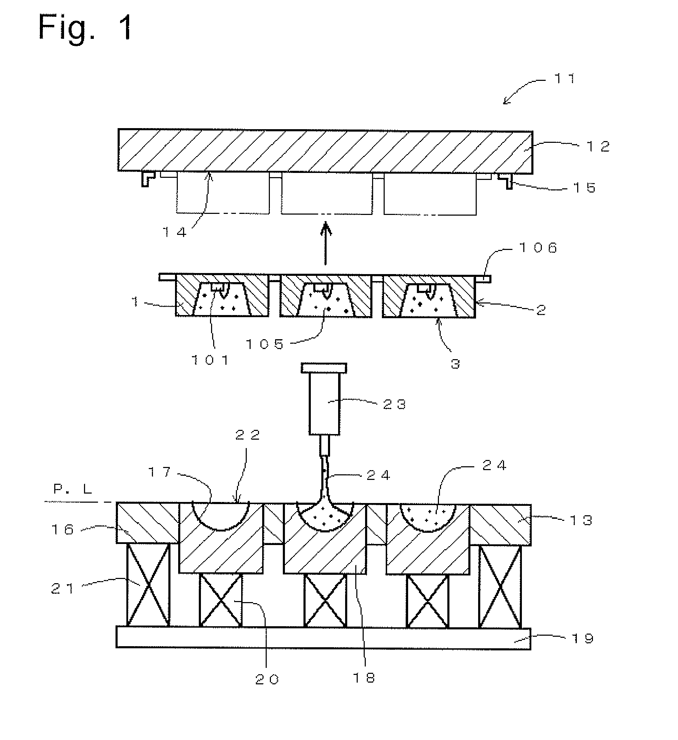

Figs. 1, 2 and 3 show a molding die for forming a light emitter (a molding die for simultaneously molding and bonding an optical member) according to the first embodiment.

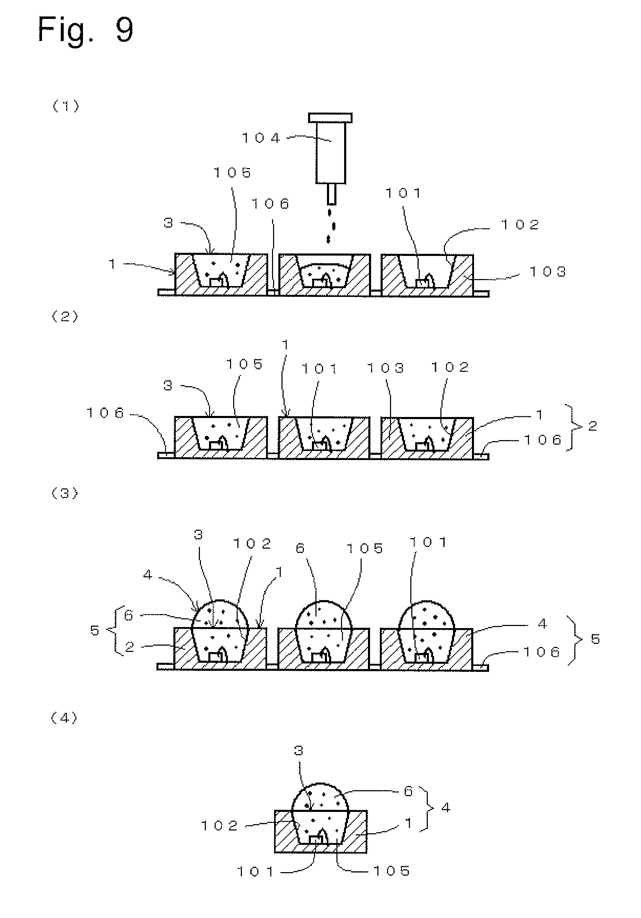

Fig. 9(1) illustrates the process of pro-molding LED light-emitting devices (light-emitting parts) used in the present invention.
Fig. 9(2) is a frame before the molding and bonding process, on which the LED light-emitting devices used in the present invention are mounted.
Fig. 9(3) is a frame after the molding and bonding process, on which light emitters (products) to be formed by the present invention are mounted.
Fig. 9(4) is the LED light emitter (product) in the present invention.

### [Details of Light-Emitting Device (Light-Emitting Part) and Light Emitter (Product)]

The process of pre-molding the LED light-emitting device 1 (light-emitting part) used in the present invention is hereinafter described using Fig. 9(1).
As shown in Fig. 9(1), the process of forming the LED light-emitting device 1 includes placing an LED chip 101 (electronic part) in a hollow 102 with a trapezoid sectional shape formed in a light-emitting device body 103 (reflector container) and then filling the hollow 102 with a resin material. As a result, the LED light-emitting device 1 in which the LED chip 101 is resin-encapsulated within the hollow 102 is obtained.
Specifically, as shown in the illustrated example, the LED light-emitting device 1 in which the LED chip 101 in the hollow 102 is resin-encapsulated can be obtained by dripping a transparent liquid resin material 105 from a dispenser 104 into the hollow 102 and then pre-molding (or hardening) the resin material.
This light-emitting device 1 is designed to emit light from the emission surface 3 when the LED chip 101 in the follow 102 is turned on.
Fig. 9(2) shows a frame 2 before the molding and bonding process. This frame 2 (which is hereinafter called the "ante-molding/bonding frame" 2) consists of a frame 106 (e.g. metal frame or lead frame) on which a required number of light-emitting devices 1 jointed together are mounted.
Fig. 9(3) shows a frame 5 after the molding and bonding process. This frame 5 (which is hereinafter called the "post-molding/bonding frame" 5) consists of the frame 106 on which a required number of light emitters 4 are mounted. The light emitter 4 (product), which is also shown in Fig. 9(4), is formed by providing a lens member 106 on the emission surface 3 of the light-emitting device 1.
The post-motding/bonding frame 5 with the required number of light emitters 4 is used as a surface light source.
As stated earlier, Fig. 9(4) shows the light emitter 4 (product) consisting of the light-emitting device 1 having the emission surface 3 on which the lens member 106 is formed. This light emitter 4 (LED light-emitting device) is obtained by cutting and removing the frame portion 106, which is unnecessary for the final product, from the post-molding/bonding frame 5 shown in Fig. 9(3).
The light emitter 4 that has been individually separated is used as an independent light source.
Accordingly, the first embodiment is a method that uses the molding die shown in Figs. 1, 2 and 3 to form the post-molding/bonding frame 5 shown in Fig. 9(3) [and the light emitter 4 shown in Fig. 9(4)] by simultaneously performing the processes of compression-molding the lens member 6 on the light-emitting device 1 mounted on the ante-molding/bonding frame 2 shown in Fig. 9(2) and bonding the lens member 6.

### (Configuration of Molding Die for Forming Light Emitter)

The molding die 11 for forming a light emitter (a molding die for simultaneously molding and bonding an LED light-emitting device) shown in Figs. 1, 2 and 3 is hereinafter described.
The molding die 11 shown in the illustrated example includes a fixed upper die 12 and a movable lower die 13 facing the upper die 12. The upper and lower dies 12 and 13 are provided with a heating means (now shown) for heating the two dies 12 and 13 to a required temperature and also a clamping means (not shown) for clamping the two dies 12 and 13 by a required clamping pressure.
In the molding surface of this upper die 12, a frame-setting section 14 is formed, on which an ante-molding/bonding frame 2 with a required number (three in the illustrated example) of light-emitting devices 1 mounted thereon is to be supplied and set. The ante-molding/bonding frame 2 can be supplied and set on the setting section 14 of the upper die 12 with a frame-fixing means 15 such as metal clips, with the emission surface 3 of the light-emitting device 1 directed toward the lower die 13 (i.e. downwards).
The lower die 13 includes a lower die body 16 and cavity blocks 18 each having a molding surface in which a cavity 17 for molding and bonding an optical member is formed. For the lower die body 16, there are a required number (three in the illustrated example) of cavity blocks 18, each of which can individually slide in the vertical direction (or the clamping direction).
As will be described later, the molding die in the illustrate example is designed so that the lens member 6 (optical member) will be compression-molded (resin-encapsulated) within the cavity 17. The resultant lens member will be a convex lens having a required shape in accordance with the required shape of the cavity 17.
As will also be described later, the lens member 6 can be bonded (in the attached state) to the emission surface 3 of the light-emitting device 1 when it is hardening during the compression-molding process within the cavity 17.

The lower die 13 includes: a base 19 located in the lower portion of the lower die 13; cavity elastic members 20, such as compression springs, provided between the base 19 and the cavity blocks 18 for producing an elastic pressing and bonding force; and a lower die elastic member 21, such as a compression spring, provided between the base 19 and the lower die body 16 as a buffer for adjusting the position of the molding surface.
Thus, the present molding die is designed so that the cavity blocks 18 will be individually and elastically biased upwards (toward the upper die) by the elastic members 20 when the upper and lower dies 11 (12 and 13) are clamped together. The molding surface side of each cavity block 18, including the mouth 22 of the cavity 17, will be individually pressed (bonded) onto the corresponding emission surface 3 of the light-emitting device 1 by a required elastic force.
The previously described configuration is intended to efficiently prevent a gap from being formed between the molding surface of the cavity block 18 and the emission surface 3 even if, for example, the light-emitting devices 1 mounted on the frame 106 are uneven in their height (or in the distance between the surface of the frame on which no light-emitting device is mounted and their emission surfaces).
Thus, the present molding die is designed to efficiently prevent resin burrs from being formed between the molding surface of the cavity block 18 (lower die 13) and the emission surface 3 and thereby efficiently improve the manufacturing efficiency of the product (light emitter 4).
When the upper and lower dies 12 and 13 are clamped together, the lower die body 16 is elastically pushed upwards (toward the upper die) by the lower die elastic member 21, whereby the molding surface of the lower die body 16 (lower die 13) is brought into contact with the emission surface 3 of the light-emitting device 1 supplied and set on the upper die 12. Thus, the position of the molding surface of the lower die body 16 can be elastically adjusted.
In the illustrated example, the face width of the light-emitting device 1 on the side of the emission surface 3 is larger than that of the molding surface of the cavity block 18. It is also possible to conversely make the width of the molding surface of the cavity block 18 larger than the face width of the light-emitting device 1 on the side of the emission surface 3.

The upper and lower dies are provided with a frame conveyer mechanism conveying the ante-molding/bonding frame 2, with a required number of light-emitting devices 1 mounted thereon, onto the setting section 14 of the upper die and a frame takeout mechanism for taking out the post-molding/bonding frame 5, although neither of these mechanisms are shown in the figures.
The frame conveyer mechanism is configured so that it can supply and set the ante-molding/bonding frame 2, with a required number of light-emitting devices 1 mounted thereon, onto the setting section 14 of the upper die, with the light-emitting devices 1 (or the emission surface 3 thereof) directed downwards. The frame takeout mechanism is configured so that it can remove the post-molding/bonding frame 5 from the setting section 14 of the upper die.

### (Process of Supplying and Compression-Molding Resin Material)

The upper and lower dies 12 and 13 are also provided with a vertical dispenser 23 (resin material supply mechanism) for dripping a required amount of transparent liquid resin material 24 into each of the cavities 17 formed in the lower-die cavity blocks 18.
The dispenser 23 is configured so that it can drip a required amount of transparent liquid resin material 24 into each of the cavities 17 (mouths 22) provided in the cavity blocks 18.
The resin 24 in the cavity 17 can be heated. Simultaneously, a required resin pressure can be applied to the resin 24 in the cavity 17 by elastically pressing the molding surface of the cavity block 18 including the cavity mouth 22 onto the emission surface 3 by a required elastic force in the process of clamping together the upper and lower dies 12 and 13.
As a result, a lens member 6 (a hardened body) having a required shape in accordance with the shape of the cavity 17 will be compression-molded within the cavity 17.
When the upper and lower dies 12 and 13 are clamped together, the molding surface (cavity mouth 22) of the cavity block 18 will be elastically pressed onto the emission surface 3 of the light-emitting device 1 by a required elastic force. As a result, the resin 24, which is hardening within the cavity 17, will be elastically pressed onto the emission surface 3 of the light-emitting device 1 (the resin 105 in the hollow 102) at the cavity mouth 22.
Thus, the lens member 6 that is compression-molded within the cavity 17 will be bonded in the attached state to the emission surface 3.
As just described, with the molding die shown in Figs. 1, 2 and 3, it is possible to simultaneously perform the processes of compression-molding the lens member 6 within the cavity 17 and bonding the same lens member 6 to the emission surface 3 by elastically pressing the molding surface of the cavity block 18 including the mouth 22 of the cavity 17 onto the emission surface 3 of the light-emitting device 1 (light-emitting part) by a required elastic force.
Therefore, as already explained, the processes of molding the lens member and bonding the same lens member can be simultaneously performed in the first embodiment.
When the heating means is energized, the heat thereby generated gradually increases the viscosity of the transparent liquid resin material supplied in the cavity 17, causing the liquid to harden (or solidify).

### (Method of Forming Light Emitter)

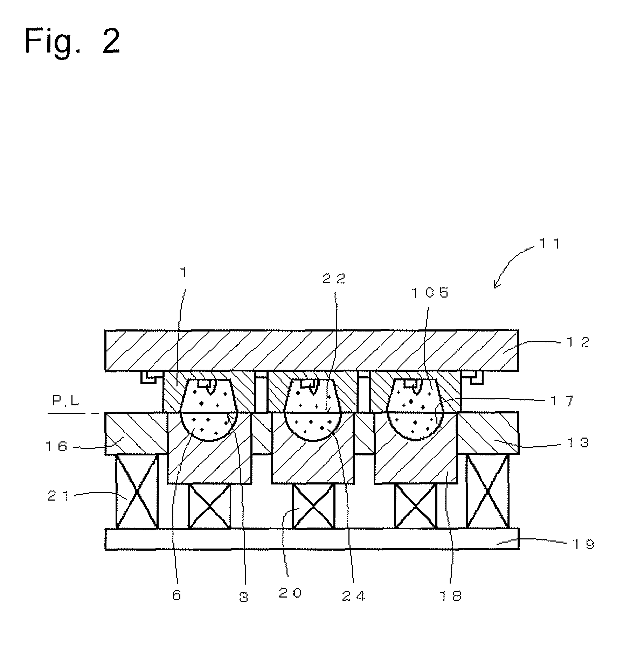

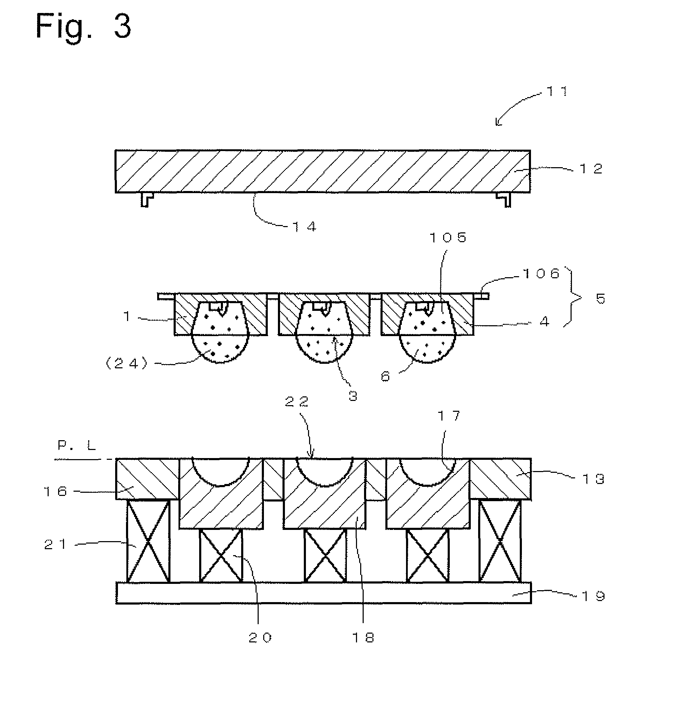

Firstly, as shown in Fig. 1, the ante-molding/bonding frame 2 with a required number of light-emitting devices 1 mounted thereon is supplied and set onto the setting section 14 of the upper die 12 by means of the aforementioned frame conveyer mechanism. Meanwhile, a required amount of transparent liquid resin material 24 is dripped by the dispenser 23 into each cavity 17 (mouth 22).
Next, as shown in Fig. 2, the upper and lower dies 12 and 13 are clamped together so that the molding surfaces (cavity mouths 22) of the cavity blocks 18 having the cavities 17 are brought into contact with the emission surfaces 3 of the light-emitting devices 1, respectively.
In this process, the emission surfaces 3 are elastically and individually pressed onto the molding surfaces of the cavity blocks 18 by the elastic members 20, respectively, whereby a required resin pressure is applied to the liquid resin material 24 in each cavity 17. As a result, the lens member 6 formed in accordance with the shape of the cavity 17 is compression-molded within the cavity 17.
The previously described process of elastically and individually pressing the molding surfaces (cavity mouths 22) of the cavity blocks 18 onto the emission surfaces 3 causes the resin (24), which is hardening within each cavity 17, to be pressed onto the emission surface 3 (resin 105). As a result, the lens member 6 that is compression-molded (resin-encapsulated) within each cavity 17 is bonded to the emission surface 3 to create the light emitter 4.
After a period of time required for the resin to harden has elapsed, the upper and lower dies 12 and 13 are opened as shown in Fig. 3 to obtain the post-molding/bonding frame 5 with the lens members 6 bonded to the emission surfaces 3 of the light-emitting devices 1, respectively.
Finally, the frame portion 106, which is unnecessary for the final product, is cut and removed from the post-molding/bonding frame 5 to obtain the light emitter 4 (product) with the lens member 6 formed on the light-emitting device 1.
Thus, with the molding die 11 for forming a light emitter, it is possible to simultaneously perform the processes of compression-molding the lens member 6 and bonding the same lens member 6, whereby the light emitter 4 with the lens member 6 molded and bonded on the light-emitting device 1 (emission surface 3) can be efficiently formed.

As described previously, the method using the molding die 11 for forming a light emitter according to the first embodiment can simultaneously perform the processes of compression-molding the lens member 6 and bonding the same lens member, so that the light emitter 4 consisting of the light-emitting device 1 and the lens member 6 can be more efficiently formed than in the conventional case where the processes of compression-molding the lens member 6 and bonding the same lens member 6 are sequentially performed.
Thus, in the case of forming the light emitter 4 (product) consisting of the light-emitting device 1 (light-emitting part) and the lens member 6 (optical part), it is possible according to the first embodiment to efficiently improve the manufacturing efficiency of the product (light emitter 4).

As described earlier, in the first embodiment, one cavity block 18 (cavity 17) is elastically and individually pressed onto each light-emitting device 1 mounted on the frame 106. Therefore, for example, in the case where the emission surfaces 3 of the light-emitting devices 1 are at different levels, when the upper and lower dies are clamped together, the molding surface of the cavity block 18 will be adjusted to the proper position by the elastic member 20, so that the molding surfaces of the cavity blocks 18 will come in contact with the emission surfaces 3 of the light-emitting devices 1, respectively.
This means, as explained earlier, that the present molding die can efficiently prevent a gap from being formed between the molding surface of the cavity block 18 and the emission surface 3. Therefore, resin burrs are efficiently prevented from penetrating into the gap between the molding surface of the cavity block 18 and the emission surface 3 from the cavity 17.
Thus, according to the first embodiment, it is possible to efficiently prevent resin burrs from penetrating into the aforementioned gap and thereby efficiently improve the manufacturing efficiency of the product (light emitter 4).

In the first embodiment, it is possible to use a mold release film.
Specifically, the mold release film is designed so that it can conform to the shape of the molding surface of the lower die 13 and the cavities 17 of the cavity blocks 18.
This configuration allows the lens member 6 molded in the cavity 17 to be efficiently released from the cavity 17 (refer to the second embodiment).

### SECOND EMBODIMENT

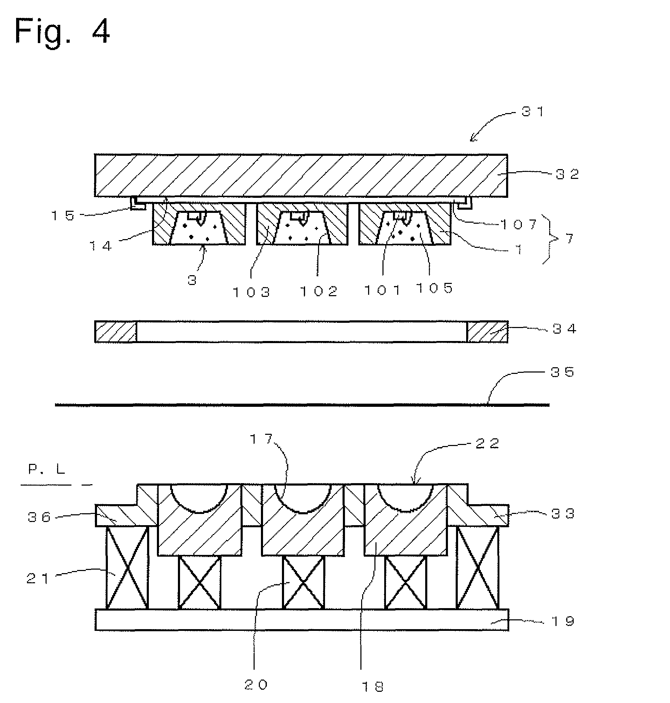

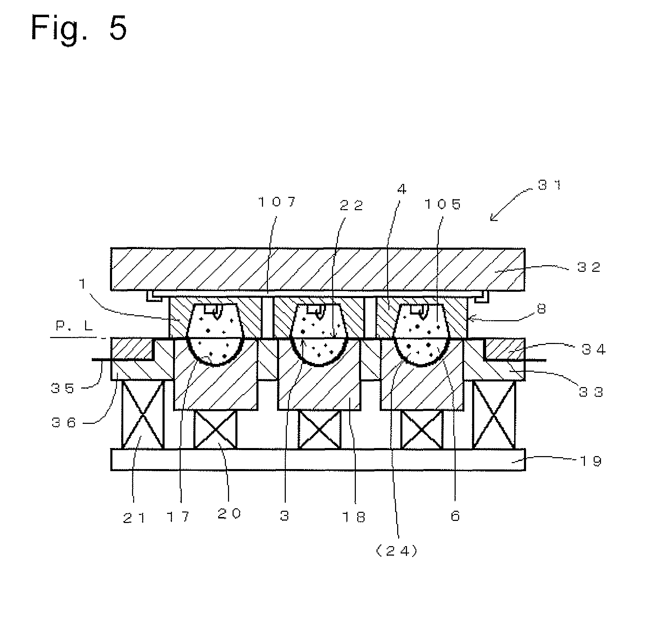

The second embodiment is hereinafter described using Figs. 4 and 5.
Figs. 4 and 5 show the molding die for forming a light emitter according to the second embodiment (a molding die for simultaneously molding and bonding an optical member). This molding die consists of upper, central and lower dies, in which a mold release film is additionally used.
The basic configuration and other features of the molding die for forming a light emitter according to the second embodiment are identical to those of the molding die according to the first embodiment. Therefore, the same numerals are also used in the present embodiment.
The molding die in the second embodiment is designed to achieve the same operations and effects as in the first embodiment.

### (Configuration of Molding Die for Forming Light Emitter)

The molding die 31 for forming a light emitter shown in Figs. 4 and 5 includes a fixed upper die 32, a movable lower die 33 facing the upper die 32, and a central die 34 (intermediate plate) provided between the upper die 32 and the lower die 33, with a mold release film 35 stretched between the central die 34 and the lower die 33.
The mold release film 35 can be sandwiched between the lower die 33 and the central die 34. The film can cover the inner surface of the cavity 17 in accordance with the shape of the cavity 17.
As in the first embodiment, the lower die 33 has cavity blocks 18 (cavities 17) fitted in the lower die body 36 in a vertically slidable manner, each cavity block being elastically supported by an elastic member 20.
The ante-molding/bonding frame 7 used in the second embodiment consists of a frame 107 (e.g. a metal frame or lead frame) with a required number of light-emitting devices 1 (light-emitting parts) mounted thereon. A post-molding/bonding frame 8 (i.e. the frame 107 with the light emitters 4) can be obtained by molding and bonding the lens members 6 by means of the molding die shown in Figs. 4 and 5.
That is to say, the cavity mouth 22 can be elastically pressed by a required elastic force onto the emission surface 3 of the light-emitting device 1 mounted on the ante-molding/bonding frame 7 supplied and set on the upper die 32.
A required amount of transparent liquid resin material 24 can be dripped into each cavity 17 covered with the mold release film 35. The mold release film 35 allows the lens member 6 (optical part), which is compression-molded within the cavity 17 in accordance with the shape of the cavity 17, to be efficiently released from the cavity 17.
As just described, the molding die in the second embodiment is designed so that the lens member 6, which is compression-molded within the cavity 17 with a shape corresponding to that of the cavity 17, can be directly formed (bonded) on the emission surface 3 of the light-emitting device 1 as in the first embodiment. This means, as explained earlier, that the processes of molding the lens member and bonding the same lens member can be performed simultaneously.

### (Method of Forming Light Emitter)

The initial step is similar to that in the first embodiment. That is, as shown in Fig. 4, the ante-molding/bonding frame 7 is supplied and set on the frame-setting section 14 provided in the upper die 32 of the molding die 31. Meanwhile, a transparent liquid resin material 24 is supplied and set into each cavity 17 covered with the mold release film 35. Then, as shown in Fig. 5, the molding die 31 (32, 33 and 34) is closed.
In this process, as in the first embodiment, the molding surfaces (cavity mouths 22) of the cavity blocks 18 provided with the cavity 17 are elastically pressed onto the emission surfaces 3 of the light-emitting devices 1 by a required elastic force. Simultaneously, a required resin pressure is applied to the resin in each cavity 17 covered with the mold release film 35.
As a result, within each cavity 17 covered with the mold release film 35, the resin (24) in the cavity 17 is compression-molded (resin-encapsulated) into the lens member 6 formed in accordance with the shape of the cavity, as in the first embodiment.
Simultaneously, the resin, which is hardening within each cavity 17 covered with the mold release film 35, is elastically pressed onto the emission surface 3 of the light-emitting device 1 (resin 105), as in the first embodiment.
As described previously, by using the molding die 31 for forming a light emitter according to the second embodiment, it is possible to simultaneously perform the processes of compression-molding the lens member 6 and bonding the same lens member 6, so that the light emitter consisting of the light-emitting device 1 and the lens member 6 can be more efficiently formed than in the case of the conventional example in which the processes of compression-molding the lens member 6 and bonding the same lens member 6 are sequentially performed.
Thus, in the case of forming the light emitter 4 (product) consisting of the light-emitting device 1 and the lens member 6, it is possible according to the second embodiment to efficiently improve the manufacturing efficiency of the product (light emitter 4).
Furthermore, as in the first embodiment, the molding die in the second embodiment can efficiently prevent a gap from being formed between the molding surface of the cavity block 18 and the emission surface 3. Therefore, resin burrs are efficiently prevented from penetrating into the gap between the molding surface of the cavity block 18 and the emission surface 3 from the cavity 17, so that the manufacturing efficiency of the product (light emitter 4) is efficiently improved.
In the second embodiment, the inside of the cavity 17 can be covered with the mold release film 35. Therefore, the lens member 6 can be efficiently released from the cavity 17 covered with the mold release film 35.

### THIRD EMBODIMENT

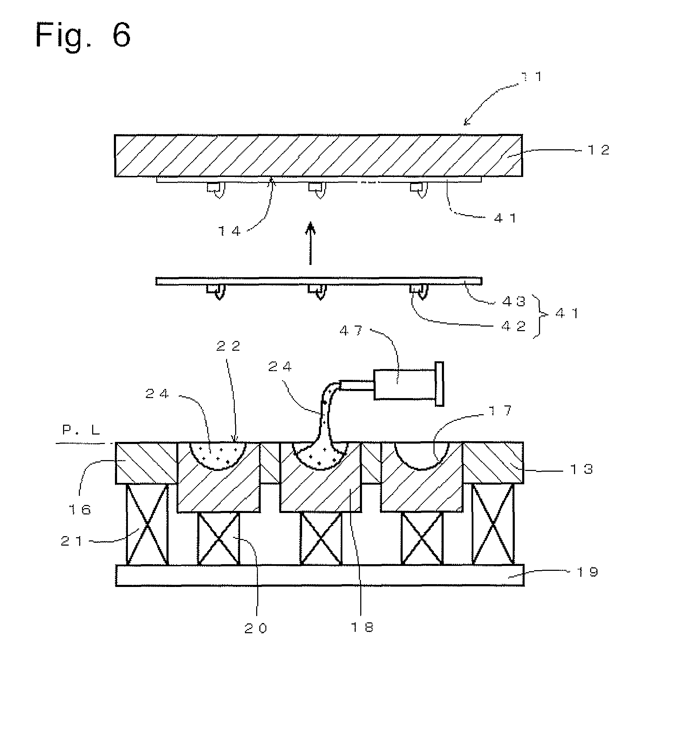

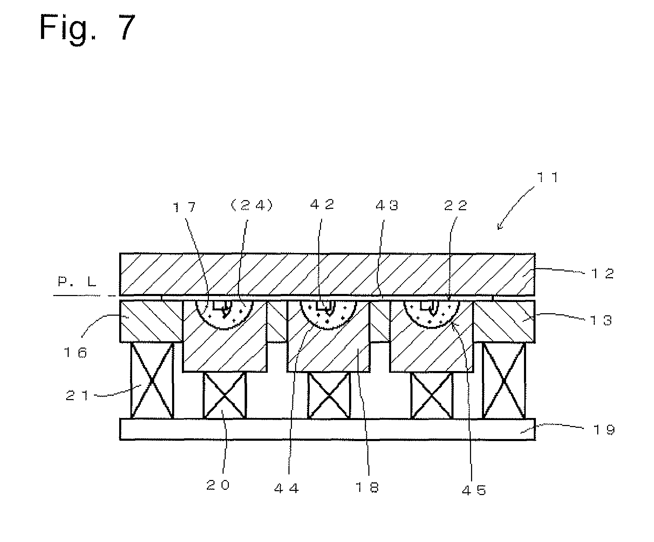

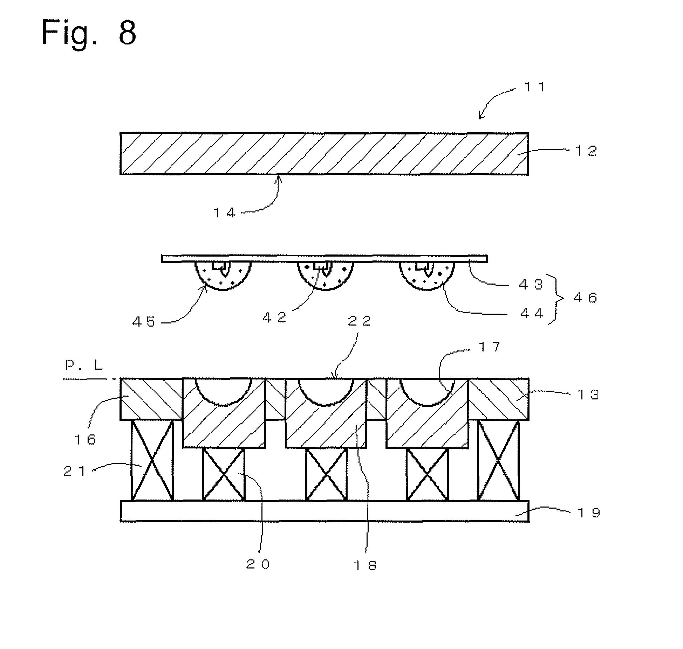

The third embodiment is hereinafter described using the molding die for forming a light emitter (a molding die for compression-molding an optical element) shown in Figs. 6, 7 and 8.
The basic configuration and other features of the molding die used in the third embodiment are identical to those of the molding die shown in the first embodiment. Therefore, the same numerals are also used in the present embodiment.

### [Molding Die for Forming Light Emitter (Molding Die for Compression-Molding Optical Element)]

An ante-molding frame 41 used in the third embodiment 3 is a frame 43 with LED chips 42 (optical elements) mounted thereon. Each LED chip 42 can be resin-encapsulated in a lens member 44 having a required shape in accordance with the shape of the cavity 17, by compression-molding the LED chip 42 by means of the molding die 11 shown in Figs. 6, 7 and 8.
The lens member 44 and the frame portion constitute a light emitter 45, and this light emitter 45 (lens member 44) will be mounted on the frame 43 to construct a molded frame 46. This molded frame 46 will be finally cut at predetermined positions to be the light emitter 45 (product).
In the third embodiment, after a transparent liquid resin material 24 is dripped by a horizontal dispenser 47 into each of the cavities 17 provided in the lower die 13, the molding die 11 (12 and 13) will be closed, whereby the LED chip 42 in the light emitter 45 (lens member 44) formed in accordance with the shape of the cavity will be compression-molded (resin-encapsulated) within the cavity 17 to create the light emitter 45 (product).

### [Method of Forming Light Emitter (Method of Compression-Molding Optical Element)]

Firstly, as shown in Fig. 6, the frame 43 (ante-molding frame 41) with the LED chips 42 (optical parts) mounted thereon is supplied and set onto the frame-setting section 14 provided in the upper die 12, with the LED chips 42 directed downwards. Meanwhile, the transparent liquid resin material 24 is supplied by the horizontal dispenser 47 into each cavity 17.
This process may further include securely absorbing the ante-molding frame 41 onto the setting section 14.
Next, the upper and lower dies 11 (12 and 13) are clamped together by a required clamping force, with the LED chips 42 immersed in the resin (24) contained in the cavities 17, to compression-mold (resin-encapsulate) each LED chip 42 within a compression-molding area (resin-encapsulating area) provided on the frame 43 for each cavity mouth 22.
In this process, the molding surfaces of the cavity blocks 18 having the cavities 17 (cavity mouths 22) are elastically and individually pressed onto the surface of the frame 43 by the elastic members 20, whereby the gap is efficiently prevented from being formed between the molding surface of the lower die 13 and the surface of the frame 43.
After a period of time required for the resin to harden has elapsed, the LED chip 42 is resin-encapsulated in the lens member 44 formed within the cavity 17 in accordance with the shape of the cavity 17. Thus, the light emitter 45 (molded frame 46) is formed.

There is one additional item that should be explained regarding the third embodiment: As explained earlier, the study objective in the first and second embodiments was to efficiently improve the manufacturing efficiency of the molded frame 5 (light emitter 4) shown in the illustrated example. However, in the third embodiment, the study is focused on the molded frame 46 (light emitter 45), which is created by structurally improving the previous light emitter 4, in order to efficiently improve the manufacturing efficiency of the product (light emitter 4).
That is, the light emitter 45 includes the lens member 44 in which the LED chip 42 mounted on the frame 43 is compression-molded (resin-encapsulated). This configuration is obtained by omitting the light-emitting device 1 from the light emitter 4 shown in the first and second embodiments. Accordingly, it is possible to omit the process of forming the light-emitting device 1 and thereby efficiently improve the manufacturing efficiency of the product (light emitter 4).
Thus, similar to the preceding embodiments, it is possible to efficiently improve the manufacturing efficiency of the product (light emitter 4) by compression-molding the LED chip 42 mounted on the frame 43 by means of the molding die 11 used in the third embodiment 3 (which is identical to the one used in the first embodiment)

Furthermore, in the third embodiment, the molding surfaces of the cavity blocks 18 are elastically and individually pressed onto the surface of the frame 43 for each of the LED chips 42, whereby the gap is prevented from being formed between the surface of the frame 43 and the molding surface of the cavity block 18.
Thus, according to the third embodiment, it is possible to efficiently prevent resin burrs from being formed on the surface of the frame 43 and thereby efficiently improve the manufacturing efficiency of the product (light emitter 45).

As in the preceding embodiments, it is possible in the third embodiment to use a mold release film (35).

The present invention is not limited to the previously described embodiments; the configurations in those embodiments may be arbitrarily and appropriately modified or selected as needled without departing from the spirit of the present invention.

In any of the previous embodiments, it is also possible to shut a region which includes at least the inside of the cavity, off from outside air, then forcefully evacuate air from the outside-air shut-off region by a vacuum mechanism such as a vacuum pump to achieve a specified degree of vacuum, and finally compression-mold the lens member (optical member) within the cavity in accordance with the shape of the cavity.

In any of the previous embodiments, it is possible to simultaneously perform the supplying of the ante-molding frame and the supplying of the resin material by the dispenser.

In the previous embodiments, the lens member (optical part) having a required shape was assumed to be a convex lens. However, the lens member may have various shapes, such as a concave lens or Fresnel lens.

The resin material used in the previous embodiments was a thermosetting resin, which may be replaced by a thermoplastic resin.

The resin material used in the previous embodiments was a liquid resin, which may be replaced by various forms of resin materials, such as a powdered resin or granular resin.
In the case of using a powdered resin, granular resin or similar type of resin, it is naturally necessary to heat the resin material into a molten state inside the cavities.

Examples of the resin material used in the previous embodiments include silicon resins and epoxy resins.
The resin material used in the previous embodiments was assumed to be a transparent resin, which may be replaced by various kinds of resin materials, such as a translucent resin or a resin containing a phosphorescent or fluorescent material.

## Claims

1. A method of forming a light emitter, using a molding die including upper and lower dies for forming a light emitter, which is **characterized by** following processes:
supplying and setting a frame, with a required number of light-emitting parts mounted thereon, onto a frame-setting section provided in the upper die, and also supplying a required amount of resin material into each of cavities of cavity blocks provided in the lower die in a vertically slidable manner, each cavity block having the cavity for molding and bonding an optical member;
closing the molding die;
elastically and individually pressing cavity mouths of the cavity blocks onto emission surfaces of the light-emitting parts, respectively, in the process of closing the molding die;
compression-molding the resin in the cavities to form the optical members in the process of elastically pressing the cavities;
bonding the optical members, which have been individually molded within the cavities in accordance with a shape of the cavity, to the light-emitting parts, respectively, in the process of elastically pressing the cavities; and
simultaneously performing the processes of compression-molding the optical members and bonding the optical members to the light-emitting parts, to form a light emitter including the light-emitting part and the optical member.

2. A method of forming a light emitter, using a molding die including upper and lower dies for forming a light emitter, which is **characterized by** following processes:
supplying and setting a frame, with a required number of light-emitting parts mounted thereon, onto a frame-setting section provided in the upper die, and also supplying a required amount of resin material into each of cavities of cavity blocks provided in the lower die in a vertically slidable manner, each cavity block having the cavity for molding and bonding an optical member;
closing the molding die;
elastically and individually pressing cavity mouths of the cavity blocks onto emission surfaces of the light-emitting parts, respectively, in the process of closing the molding die; and
immersing the light-emitting parts in the resin contained in the cavities and compression-molding the light-emitting parts in the process of elastically pressing the cavities, to resin-encapsulate, within each cavity, an optical part in the optical member formed in accordance with a shape of the cavity and thereby form a light emitter.

3. The method of forming a light emitter according to claim 1 or 2, which is **characterized by** a process of covering an inner surface of the cavities with a mold release film before supplying the resin material into the cavities.

4. The method of forming a light emitter according to claim 1 or 2, which is **characterized by** processes of shutting off outside air from, at the very least, an inside of the cavities provided in the molding die, thus forming an outside-air shut-off region, and then forcefully evacuating air from the outside-air shut-off region to maintain the outside-air shut-off region at a required degree of vacuum.

5. A molding die for forming a light emitter, which is **characterized by**: an upper die; a lower die facing the upper die; a setting section provided in the upper die, onto which a frame with a required number of optical parts mounted thereon is to be supplied and set; a required number of lower-die cavities formed for the optical parts, respectively; cavity blocks provided in the lower die in a vertically slidable manner, each cavity block having one of the cavities; and elastic bodies elastically supporting each of the cavity blocks upwards.

6. The molding die for forming a light emitter according claim 5, which is **characterized by** a mold release film for covering an inner surface of the cavities.

7. The molding die for forming a light emitter according claim 5, which is **characterized by** a vacuum mechanism for forcefully evacuating air from an outside-air shut-off region which at least includes an inside of the cavities to maintain the outside-air shut-off region at a required degree of vacuum.

8. The molding die for forming a light emitter according claim 5, which is **characterized in that** the optical part is a light-emitting element.

## Amended claims

### Amended claims under Art. 19.1 PCT

**1.** (Amended) A method of forming a light emitter, using a molding die including upper and lower dies for forming a light emitter, which is **characterized by** following processes:
supplying and setting a frame, with a plurality of pre-molded light-emitting parts mounted thereon, onto a frame-setting section provided in the upper die, and also supplying a required amount of resin material into each of cavities of a plurality of cavity blocks provided in the lower die in a vertically slidable manner, each cavity block having the cavity for molding and bonding an optical member;
closing the molding die;
elastically and individually pressing cavity mouths of the cavity blocks onto emission surfaces of the light-emitting parts, respectively, in the process of closing the molding die;
compression-molding the resin in the cavities to simultaneously form lens members in the process of elastically pressing the cavities;
individually and simultaneously bonding the lens members, which have been independently molded within the cavities in accordance with a shape of the cavity, to the light-emitting parts, respectively, in the process of elastically pressing the cavities; and
simultaneously performing the processes of compression-molding the lens members and bonding the lens members to the light-emitting parts, to form a light emitter including the light-emitting part and the lens member.

**2.** (Amended) A method of forming a light emitter, using a molding die including upper and lower dies for forming a light emitter, which is **characterized by** following processes:
supplying and setting a frame, with a plurality of light-emitting parts mounted thereon, onto a frame-setting section provided in the upper die, and also supplying a required amount of resin material into each of cavities of a plurality of cavity blocks provided in the lower die in a vertically slidable manner, each cavity block having the cavity for molding and bonding an optical member;
closing the molding die;
elastically and individually pressing cavity mouths of the cavity blocks onto emission surfaces of the light-emitting parts, respectively, in the process of closing the molding die; and
immersing the light-emitting parts in the resin contained in the cavities and compression-molding the light-emitting parts in the process of elastically pressing the cavities, to individually and simultaneously resin-encapsulate, within each cavity, the optical part in a lens member each formed in accordance with a shape of the cavity and thereby form a light emitter.

**3.** (Original) The method of forming a light emitter according to claim 1 or 2, which is **characterized by** a process of covering an inner surface of the cavities with a mold release film before supplying the resin material into the cavities.

**4.** (Original) The method of forming a light emitter according to claim 1 or 2, which is **characterized by** processes of shutting off outside air from, at the very least, an inside of the cavities provided in the molding die, thus forming an outside-air shut-off region, and then forcefully evacuating air from the outside-air shut-off region to maintain the outside-air shut-off region at a required degree of vacuum.

**5.** (Amended) A molding die for forming a light emitter, which is **characterized by**: an upper die; a lower die facing the upper die; a setting section provided in the upper die, onto which a frame with a plurality of optical parts mounted thereon is to be supplied and set; a plurality of cavity blocks provided in the lower die in a vertically slidable manner, a plurality of lower-die cavities corresponding to the optical parts, each cavity being independently formed in each cavity block and having a lens shape; and elastic bodies elastically supporting each of the cavity blocks upwards.

**6.** (Original) The molding die for forming a light emitter according claim 5, which is **characterized by** a mold release film for covering an inner surface of the cavities.

**7.** (Original) The molding die for forming a light emitter according claim 5, which is **characterized by** a vacuum mechanism for forcefully evacuating air from an outside-air shut-off region which at least includes an inside of the cavities to maintain the outside-air shut-off region at a required degree of vacuum.

**8.** (Original) The molding die for forming a light emitter according claim 5, which is **characterized in that** the optical part is a light-emitting element.
